# EUROPEAN PATENT SPECIFICATION

(11) **EP 1 719 250 B1**
(45) Date of publication and mention of the grant of the patent: **14.07.2010**
(21) Application number: 05702999.3
(22) Date of filing: 17.02.2005
(51) Int. Cl.: H04B 1/04, H03G 3/20, H03G 3/30, G01R 27/06

(54) **LOAD INSENSITIVE POWER AMPLIFIER**
LASTUNEMPFINDLICHER LEISTUNGSVERSTÄRKER
AMPLIFICATEUR DE PUISSANCE INSENSIBLE A LA CHARGE

(30) Priority: 27.02.2004 GB 0404371
(43) Date of publication of application: 08.11.2006
(73) Proprietor: NXP B.V., 5656 AG Eindhoven (NL)
(72) Inventor: NAM, Sueng-Il, Philips Intellectual P & S, Redhill Surrey RH1 5HA (GB)
(74) Representative: Schouten, Marcus Maria
(86) International application number: PCT/IB2005/050597
(87) International publication number: WO 2005/086360

(56) References cited:
- EP-A- 1 120 907
- DE-A1- 2 710 752
- DE-A1- 10 015 684
- US-A1- 2003 114 182

## Description

This invention relates to power amplifiers, to transceivers, integrated circuits having the same, and to methods of controlling and methods of manufacturing the same.

Power amplifiers are used in a number of applications where reflections are an issue. One example is in wireless communications. A typical transceiver used to transmit voice and data communications has a transmitter with a power amplifier to output voice and data signals via an antenna. To promote transmission efficiency, this power amplifier is typically optimized for the anticipated load. When the power amplifier is presented with a load that differs from the anticipated load, a significant portion of the power output by the power amplifier is reflected back to the amplifier and is not transmitted. As a result, the effective radiated power may be significantly reduced. In addition, the transmitted signal may be distorted, particularly as amplifier output power increases.

Such wireless communication systems can include systems using frequency division multiple access (FDMA), time division multiple access (TDMA), and various spread spectrum techniques for example. One common spread spectrum technique used in wireless communications is code division multiple access (CDMA) signal modulation. GSM systems use a combination of TDMA and FDMA modulation techniques. Some example wireless communication devices that have incorporated wireless technology include cellular radiotelephones, PCMCIA cards incorporated within portable computers, personal digital assistants (PDAs) equipped with wireless communication capabilities, and the like.

To prevent adverse effects associated with load mismatches, some devices incorporate circulators or isolators that present a fixed load to the power amplifier. Circulators and isolators pass power in one direction, but not in the reverse direction, and are therefore used to protect the output of equipment from reflected signals. Some other devices incorporate a balance amplifier to present a fixed load to the power amplifier.

Power amplifiers are one of the most difficult parts of a transceiver to integrate, because of their large voltage swing as well as high output power. This can cause a significant amount of substrate noise, which can couple to other sections of the chip causing noise problems and instability such as pulling effects of a VCO (voltage controlled oscillator). For these reasons power amplifiers usually are implemented in a separate RF module. Furthermore the performance of a separate RF module becomes significantly sensitive to load impedance. Unfortunately, in most cases the load impedance shows some variation due to non-consistent PCB integration (or antenna integration to PCB) and human touch during phone conversation. This small power amplifier (PA) load impedance variation can result in significant radiation power deterioration, causing massive PA efficiency reduction.

Impedance matching techniques for efficient and constant power (low loss) have been reported. Y, Sun and W. K. Lau, "Antenna impedance matching using genetic algorithms", National Conference on Antenna and Propagation, 30 March 1999, Conference Publication No. 461, IEE 1999 shows a complex algorithm which is not suitable for rapid impedance variations as can occur with a mobile handset unit. M. Vai and S. Prasad, "Automatic impedance matching with a neural network", IEEE Microwave and Guided wave letters, Vol. 3, No. 10, Oct 1993 shows using a PIN diode to switch between two or three fixed impedance points. However, this PIN diode technique uses VSWR as switching criteria parameter, which fundamentally limits the accuracy of load impedance determination. Furthermore, the switching technique is not able to track continuous load impedance variation since it switches between just two or three fixed impedance conditions.

It is known from US patent application 20030114182 A1 to cause the power output of a power amplifier associated with a wireless transmitter to be reduced in response to a load mismatch condition, to reduce distortion. This addresses the problem that "power amplifiers typically exhibit non-linear characteristics with increased output power, causing signal distortion". The transmitter can be in for example, a cellular radiotelephone, a satellite radiotelephone, a PCMCIA card incorporated within a portable computer, a personal digital assistant (PDA) equipped with wireless communication capabilities, and the like. In some implementations, a dual-directional coupler separates a power signal into transmitted and reflected components, which are then detected, for example, using a broadband power detector. A load mismatch criterion relative to the wireless transmitter is evaluated by a microprocessor. To conserve power and reduce signal distortion, the power output of the amplifier is reduced if the load mismatch exceeds a threshold condition. In addition, if the mismatch exceeds a further prescribed threshold, the power amplifier may be shut off. A disadvantage of reacting by reducing the power is that the variation in power seen by the receiving side will be made worse. Also, the use of a microprocessor implies the author saw no need for a fast response to rapid changes in load impedance.

Another power amplifier for mobile phones shown in US patent application 20020183021 uses a different approach. In this document it is acknowledged that changes to the load impedance are commonly caused by environmental factors. For example, if the load is an antenna of a transmitter for transmitting signals, the load impedance is dependent upon the environment surrounding the antenna. As an example, if a mobile phone is held in the hand, the impedance experienced by the power amplifier may be different from the impedance experienced by the power amplifier when the mobile phone is sitting on a table or in a car. Because the output power must be well controlled, it is desired to keep the output power constant, regardless of changes in the load impedance. The solution proposed involves the steps of (1) comparing a measured signal to a reference si gnal, wherein the measured signal represents the sum of the amplitude of the output voltage of the power amplifier and a current flowing into the power amplifier from a power supply connected to the power amplifier and (2) controlling the power amplifier based on the result of the comparison between the measured signal and the reference signal. The circuit shown includes a current detector for measuring the current flowing into the power amplifier from a power supply, an amplitude detector that measures the amplitude of the output voltage of the power amplifier, an adder for summing the output of the current detector and the amplitude detector, and a control circuit connected to a biasing pin of the power amplifier that compares the output of the adder to a reference signal and controls the power amplifier based on the result of the comparison between the reference signal and the output of the adder. The output of the adder changes as the impedance of the load on the power amplifier changes.

Because the output of the control circuit is connected to the biasing input of the power amplifier, the output of the control circuit controls the current delivered by the power amplifier to the load, and, hence, controls the power delivered to the load. When the impedance of the load changes, the control circuit increases or decreases the current delivered to the load, depending on the change in the impedance of the load.

German Patent Application 2710752A1 discloses an RF power amplifier having an amplifier and a controller having means for detecting power reflected from a load on an output of the amplifier, and means for controlling an output power of the amplifier in response to an integral over time of the detected power reflected. German Patent Application 10015684A1 discloses a similar amplifier.

There remains a need for improved handling of load impedance variation.

It is an object of the invention to provide improved apparatus or methods.

According to a first aspect of the invention, there is provided an RF power amplifier having an amplifier and a controller having means for detecting power reflected from a load on an output of the amplifier, and means for controlling an output power of the amplifier in response to an integral over time of the detected power reflected, to increase the output power to compensate for a drop in output power caused by changes in the power reflected, and to decrease the output power to compensate for an increase in output power caused by changes in the power reflected, **characterised in that** the means for controlling comprises means to determine the integral over time of the detected power reflected as the integral of a difference between a reflected signal and a reference signal, and comprising a reference generator adapted to generate the reference signal by adding an initial reference to a difference of the initial reference and the reflected signal.

This can provide advantages such as more efficient use of transmit power and more even power levels at receivers. It is based on an appreciation that detecting reflected power can be useful for much more than merely indicating that there is sufficient load mismatch to cause distortion. It can provide a better error signal for controlling output power to compensate for load changes, even better in some ways than more direct methods such as using detected changes in output voltage or output power itself directly as an error signal. This outcome will now be explained further. A detected change in output power has ambiguity over whether it is caused by an increase or a decrease in load impedance or change in phase of the load impedance, or other cause of load mismatch, or by other causes. Also a change in output power can itself change amplifier output impedance and so change load mismatch. So it leaves uncertainty over the cause and thus what amount of correction is needed to return the output power to the desired level without damaging power oscillations. In contrast, detecting reflected power can enable the output power level to be compensated more accurately and more quickly, for changes in load mismatch, since it seems to provide a more accurate and reliable error signal. It can thus reduce power level changes seen at receivers. Such a reduction in turn can lead to higher quality connections or lower bit error rates, or lower power margins and thus lower average power levels for example.

By using an integral, the amplifier can be controlled more effectively. This can be particularly effective where the output impedance of the power amplifier and thus the mismatch, varies in a complicated non linear relationship with the amplifier gain. The change of gain needed to reduce the reflection closer to zero and keep the power at the receiver constant is hard to determine accurately over a wide range. A linear feedback control without any integral component would therefore be difficult to design to reduce the reflection to zero, or to do so quickly, without oscillation. The integral is not merely bringing a better transient response to step changes, it is also providing a way to reduce the steady state error closer to zero. Hence in environments with rapidly changing load impedances it can help restrict large voltage swings on the output of the amplifier for example. This can help reduce problems such as substrate noise coupling to other parts of the device and hence make it easier to integrate more parts of the device. This can reduce manufacturing costs and/or improve the control of power level. Better control of power level has advantages for applications such as mobile phones or wireless connected computer devices in terms of longer battery life, more consistent connectivity during conversations and lower or fewer peaks in radiation levels for example. The integral is intended to encompass anything with an integral component, including for example passive or active low pass filter circuits and so on.

The means for determining the integral comprises means for determining a difference between a reflected signal and a reference, and determining an integral of this difference. This can help produce a stable control signal.

The reference generator comprises means for adding an initial reference to a difference of the initial reference and the reflected signal to generate the reference. This enables the reference signal to be centred at zero to reduce the sensitivity to any integrator offset.

As an additional feature, the means for determining an integral is implemented using solely analogue signal processing components. An advantage of an integral is that it can be implemented using relatively simple components without the need for complex calculations requiring digital processing and storage elements for example. As well as being simpler, such analogue components can often operate more quickly and thus provide better reaction to rapidly changing conditions.

As another additional feature, the means for determining the integral is integrated on a substrate with the amplifier. The relative simplicity of determining an integral can make it much easier to integrate with the power handling components, and thereby reduce size and manufacturing costs. Notably, for RF power amplifiers in particular, the silicon or GaAs processes used for such high speed high power integrated circuits are difficult and costly to combine with digital processing and memory circuitry features. Hence there is an advantage if simpler functions such as integrals can be used, which can be implemented without resorting to digital processing and memory elements. Other components of the amplifier can be integrated as well.

Another additional feature is a controllable reference generator arranged to output the reference at a selectable value. This is useful to enable the power amplifier control to be varied according to the conditions.

As an additional feature, the control comprises gain control of the amplifier.

Another aspect provides a power amplifier having an RF amplifier and a controller integrated on the same substrate as the RF amplifier and having means for determining an integral over time of a signal derived from an output of the amplifier, to represent a mismatch of a load on the output, the controller being arranged to use the integral to control the amplifier.

The use of an integral can have corresponding advantages as set out above. This is intended to encompass signals derived from the output by detecting reflections or by tapping a small part of the outgoing power amplified signal from the amplifier or other ways of deriving a representation of the instantaneous mismatch. By enabling integration of the controller with the amplifier, a universal power amplifier module can be produced which can be compatible with a range of different baseband circuitry and matching network and antenna products. In particular, some of the performance advantages of a sophisticated power amplifier controller can be obtained without the costs of needing a separate control or logic chip. Such a separate control or logic chip would probably need to be dedicated and proprietary rather than generic, and the flexibility of a universal power amplifier would be lost.

Another aspect provides an integrated circuit having the power amplifier set out above.

Another aspect provides a mobile battery powered device having a wireless transceiver, the transceiver having the power amplifier set out above.

Another aspect provides a method of controlling a power amplifier having the steps of detecting a signal reflected from a load on an output of the amplifier, determining an integral over time of the detected reflected signal, and controlling an output power of the power amplifier according to the integral, to increase the output power to compensate for a drop in output power caused by changes in the power reflected, and to decrease the output power to compensate for an increase in output power caused by changes in the power reflected, characterised by determining the integral over time of the detected power reflected as the integral of a difference between the reflected signal and a reference signal, and generating the reference signal by adding an initial reference to a difference of the initial reference and the reflected signal.

Any of the additional features can be combined together or with any of the aspects of the invention, as would be apparent to those skilled in the art.
Other advantages may be apparent to those skilled in the art, especially over other prior art not known to the inventors.

Embodiments of the invention will now be described by way of example, and with reference to the accompanying drawings, in which:
Figure 1 shows an arrangement without compensation, only power limiting, for comparative purposes;
Figures 2 and 3 show graphs of characteristics of a circuit without compensation, for comparative purposes;
Figure 4 shows an amplifier according to an embodiment;
Figure 5 shows a mobile device having an amplifier according to another embodiment; and
Figures 6 to 8 show graphs of characteristics of the embodiment of Fig 5.

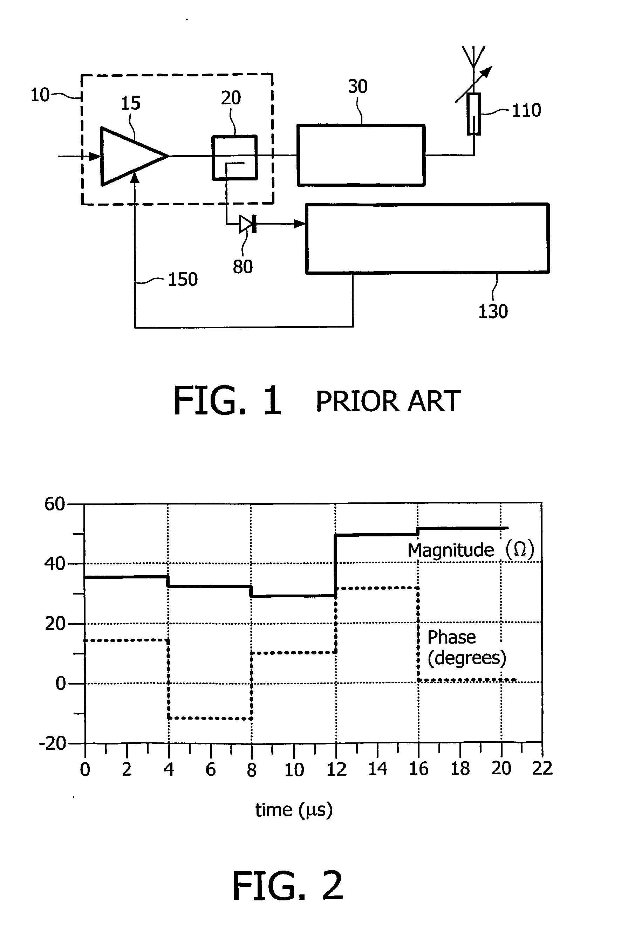

Figure 1 shows a diagram of a known transmitter front-end system having a power amplifier output impedance control technique to track vari able load impedance. The Figure shows an integrated amplifier 10, having an amplifier 15, and a coupler 20 for separating reflected signal components. A fixed matching network 30 is coupled in between the coupler 20 and an antenna 110. The fixed matching network 30 is designed to match the amplifier 15 output load impedance for maximum efficiency or maximum delivered power output. However, in practice an optimally designed fixed matching network 30 will not fully function as it is designed since load impedance is continually varying during its operation. It is also possible to have a slightly different load impedance between different devices owing to manufacturing variations such as those in the printed circuit board and power amplifier module as they are integrated during the manufacturing process. For example, consider a fixed matching network 30 matching amplifier output impedance to the antenna 110. Assume that antenna impedance (Zₐₙₜ) varies every 4 microseconds as:
5 - j*5 Ω over 0 to 4µs,
10 - j*5 Ω over 4 to 8µs,
15-j*5 Ω over 8 to 12µs,
15 - j*15 Ω over 12 to 16µs,
10 - j*10 Ω over 16 to 30µs
Resulting from this, the overall load impedance, including the fixed matching network 30 impedance and variable antenna impedance becomes:
35 + j*9.3 Ω over 0 to 4µs,
32.45 - j*6.5 Ω over 4 to 8µs,
29.7 + j*5.85 Ω over 8 to 12µs,
42.25 + j*25.8 Ω over 12 to 16µs,
51.62 + j*0.5 Ω over 16 to 30µs
The variation in overall load impedance is shown in Figure 2, with the phase and magnitude characteristics shown separately.In Figure 1, the reflected signal from the coupler 20 is fed to a diode 80 for power to voltage conversion, and then to a processor 130 for calculation of a reflection ratio and thus an amount of mismatch. The gain of the amplifier 15 is reduced according to the amount of mismatch. The amplifier 15 is controlled by a control voltage representing the amount of mismatch, on a control line 150 from the processor 130.

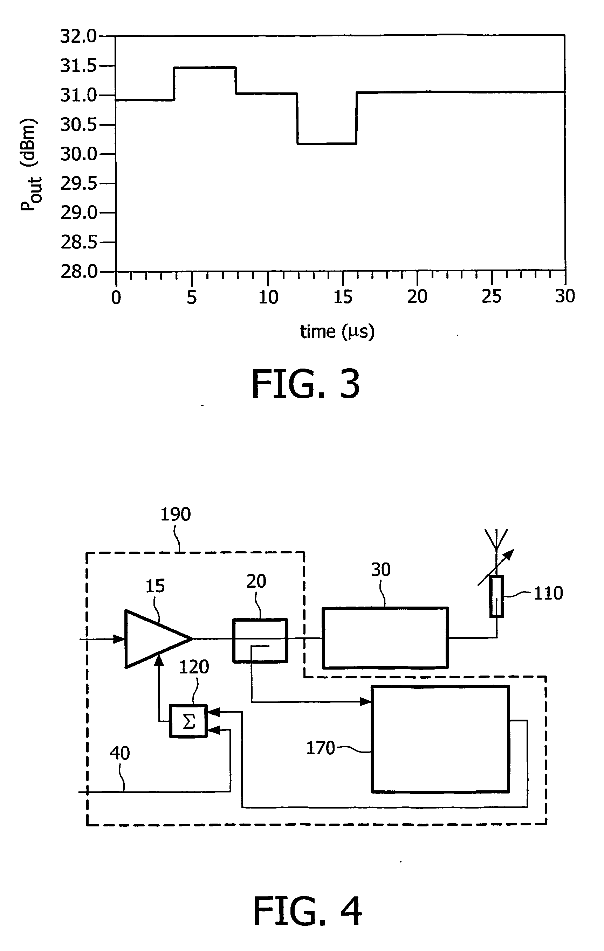

A small load impedance variation will cause significant performance degradation in terms of transmitter efficiency loss, therefore shorten battery lifetime. As can be seen from the two lines on the graph of Figure 2, the phase and magnitude of the impedance show different variations over time. Figure 3 is graph showing the amplifier 15 output power Pₒᵤₜ variation over time (and consequently variation in radiation power) caused by load impedance changes such as those shown in Figure 2. For such load impedance variation, output power variation can become well above 1.3 dBm.

Figure 4 shows an embodiment of the invention. The same reference numerals have been used to those of Figure 1 where appropriate. Notably the circuitry 170 is provided for producing an error signal from a reflection signal and representing a mismatch in the load. This circuitry 170 outputs a signal to a gain controller 120 to enable the amplifier 15 to be controlled in response to the reflected signal. The gain controller 120 sums the control signal from the circuitry 170 with a DC control voltage on an input 40 representing a target power level. Optionally the control can additionally operate on the basis of an outgoing signal from the amplifier output. The circuitry 170 can use conventional analogue signal processing components including an integrator. Suitable integrators can be built up using conventional circuit elements such as capacitors, resistors, op-amps and so on. Such circuitry can enable a more integrated power amplifier on one substrate 190. In this case all the components other than the matching network 30 and the antenna 110 can be integrated on the same substrate. This enables a universal power amplifier module to be produced which is not dependent on a proprietary control chip. It can provide some of the benefits of more sophisticated amplifier control without the additional expense of a separate chip and without the difficulties of trying to integrate digital circuitry and memory elements on the same substrate as high power RF amplification circuitry. Even the matching network 30 can be integrated if desired, depending on the application.

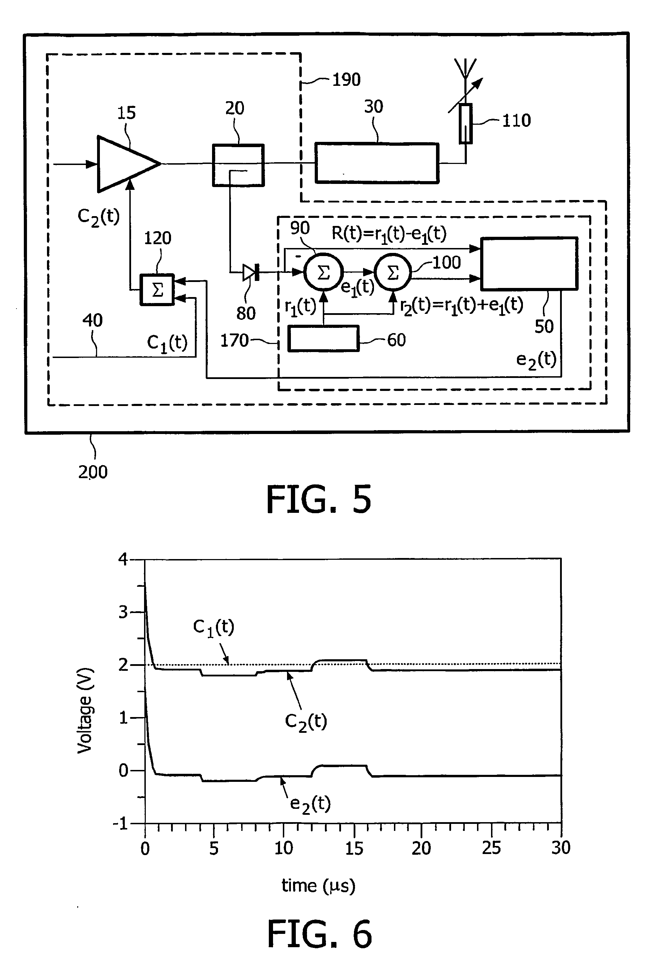

In Figure 5 an embodiment is shown for use in a mobile device 200 and showing more details of an implementation of the circuitry 170. Again the same reference numerals to those of Figures 1 and 4 have been used as appropriate. The device 200 employs a coupler 20 as before to sense reflected power in case of load impedance variation. As reflected power is very weak, the coupler will be less than 10 dB. The reflected and coupled power will be sensed in the diode detector 80 which converts reflected power into a voltage signal. Reflected voltage signal R(t) is coupled to a subtractor 90 and an integrator 50, in this case a differential input integrator having two inputs. The reflected input voltage R(t) to the subtractor 90 can be regarded as a difference of a desired reference value and an error value which should be reduced to zero, in other words, R(t)=r₁(t)-e₁(t). R(t) can be subtracted from a first reference voltage r₁(t), resulting in a first error signal e₁(t). The first error signal e₁(t) is added by adder 100 to the first reference signal r₁(t) to generate a second reference signal r₂(t), which will be used as another input for the integrator 50. The integrator 50 compares the reflected signal R(t) and the second reference signal r₂(t), and will increase its output voltage, second error signal e₂(t), when r₂(t) > R(t), and decrease its output when r₂(t)) < (R(t). Since the first error signal e₁(t) becomes zero when the reflected voltage matches the reference generated by the reference generator, the second error signal e₂(t) will be centred at zero. The second error signal e₂(t) represents a true error signal caused by output load mismatch. Finally, e₂(t) will be added to a conventional power amplifier gain control voltage C₁(t) on input 40 to form a control voltage control C₂(t) which is applied to correct the gain of the amplifier 15 to compensate for the detected change in reflection.

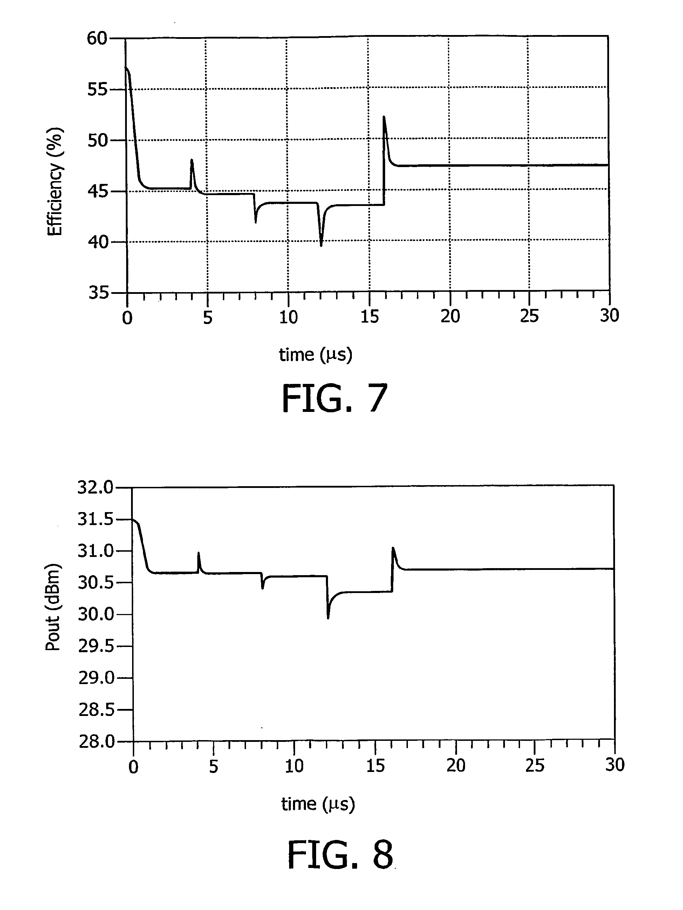

Figure 6 shows corresponding control signals generated through the proposed technique for the same load variations as shown in Figures 2 and 3. Figure 6 shows the value of the conventional power amplifier gain control voltage C₁(t) which is a straight line, the power amplifier control voltage C₂(t) output to the amplifier 15 by the gain controller 120, and the error signal e₂(t) output by the integrator 50. Figures 7 and 8 show resulting power amplifier output efficiency and power respectively when the proposed technique is applied over the same time intervals shown in Figures 2, 3 and 6. In Figure 7, the y-axis represents percentage efficiency. There are peaks or troughs in the curve where the load impedance changes as shown in Figure 2. The control circuitry 170 reacts quickly to compensate for such changes. In Figure 8, the y-axis represents the power output in dBm. Again there are peaks or troughs in the curve where the load impedance changes. As shown, where the load impedance change causes a sudden increase in output power at the 4 µsec instant, the compensating control acts to decrease the output power quickly back to its previous value. A sudden decrease at the 8 µsec instant caused by an increase in load impedance is met by a compensating increase in power output to return the output power quickly back to its previous value. The change at 12µsec instant is compensated quickly but not fully back to the original value. It may be beyond the capability of the amplifier 15 to fully compensate across a wide range of load impedance changes. Nevertheless such partial compensation still improves the power regulation and reduces the power level changes, and so is intended to be encompassed by the claims.

A similar result can be achieved in principle with a single input integrator, when first error signal e₁(t) directly drives the integrator 50 as the reference signal (in this case the whole system becomes more sensitive to integrator off-set voltage). In principle, the integrator 50 can be replaced in some applications by a proportional or other type of controller to generate a suitable control signal to compensate for the detected changes in reflected power.

The first reference signal r₁(t) from the reference generator 60 can be arranged to provide a fixed reference voltage, or a selectable reference voltage. The latter way can employ a look-up table for example, or use conventional analogue circuitry such as analogue reference generators and switches. The reference voltage value can be decided through measurement. Thus, with a fixed matching network 30, the reference voltage r₁(t) can be selected according to an expected or targeted load condition (either to aim for maximum efficiency or for maximum power condition for example) and the amount of reflected power can be measured. This measured voltage will be adopted as reference voltage r₁(t). For the selectable output look-up table, measurements can be made for several different load conditions. During operation, a different value for reference r₁(t) can be selected if the conditions change sufficiently.

As has been described above, a power amplifier for mobile phones has an RF amplifier (15) controlled based on an integral over time of a signal representing an amount of power reflected from a load on an output of the amplifier. Using an integral, the control can be more effective where there are changeable load impedances. It can restrict large voltage swings on the amplifier output. As the integral can be determined using analogue signal processing components (50, 90, 100) it can be integrated more easily with RF and other components. The integral can be determined of a difference relative to a reference. The reflection signal can be centred on zero before integrating to reduce sensitivity to offset. The reference can be selectable to suit the conditions.

In the present specification and claims the word "a" or "an" preceding an element does not exclude the presence of a plurality of such elements. Further, the word "comprising" does not exclude the presence of other elements or steps than those listed.

The inclusion of reference signs in parentheses in the claims is intended to aid understanding and is not intended to be limiting.

From reading the present disclosure, other modifications will be apparent to persons skilled in the art. Such modifications may involve other features which are already known in the art of power amplifier design and which may be used instead of or in addition to features already described herein.

## Claims

1. An RF power amplifier having an amplifier (15) and a controller (20,170) having means (20) for detecting power reflected from a load on an output of the amplifier (15) , and means (170) for controlling an output power of the amplifier (15) in response to an integral over time of the detected power reflected, to increase the output power to compensate for a drop in output power caused by changes in the power reflected, and to decrease the output power to compensate for an increase in output power caused by changes in the power reflected, **characterised in that**
the means (170) for controlling comprises means (50) to determine the integral over time of the detected power reflected as the integral of a difference between a reflected signal (R(t)) and a reference signal (r₂(t)), and comprising a reference generator (60, 90, 100) adapted to generate the reference signal (r₂(t)) by adding an initial reference (r₁(t)) to a difference of the initial reference (r₁(t)) and the reflected signal (R(t)).

2. The power amplifier of claim 1, the means (50) for determining the integral being implemented using solely analogue signal processing components.

3. The power amplifier of any preceding claim, the means (50) for determining the integral being integrated on a substrate with the amplifier (15).

4. The power amplifier of any preceding claim, the reference generator (60, 90, 100) being arranged to output the initial reference (r₁(t)) at a selectable value.

5. The power amplifier of any preceding claim, wherein the means (170) for controlling the output power of the amplifier (15) is adapted to control the gain of the amplifier (15).

6. A mobile battery powered device (200) having a wireless transceiver, the transceiver having the power amplifier of any preceding claim.

7. A method of controlling a power amplifier having the steps of detecting a signal reflected from a load on an output of the amplifier (15), determining an integral over time of the detected reflected signal (R(t)), and controlling an output power of the power amplifier according to the integral, to increase the output power to compensate for a drop in output power caused by changes in the power reflected, and to decrease the output power to compensate for an increase in output power caused by changes in the power reflected, **characterised by**
determining the integral over time of the detected power reflected as the integral of a difference between the reflected signal (R(t)) and a reference signal (r₂(t)), and generating the reference signal (r₂(t)) by adding an initial reference (r₁(t)) to a difference of the initial reference (r₁(t)) and the reflected signal (R(t)).

## Patentansprüche

1. HF-Leistungsverstärker, der einen Verstärker (15) und eine Regelungsvorrichtung (20, 170) aufweist, die Mittel (20) zum Erfassen der von einer Last an einem Ausgang des Verstärkers (15) reflektierten Leistung aufweist, sowie Mittel (170) zum Regeln einer Ausgangsleistung des Verstärkers (15) in Reaktion auf ein Integral der erfassten reflektierten Leistung über der Zeit, um die Ausgangsleistung zu erhöhen und ein durch Änderungen der reflektierten Leistung hervorgerufenes Absinken der Ausgangsleistung zu kompensieren, und um die Ausgangsleistung zu senken und eine durch Änderungen der reflektierten Leistung hervorgerufene Erhöhung der Ausgangsleistung zu kompensieren, **dadurch gekennzeichnet, dass**
die Mittel (170) zum Regeln Mittel (50) umfassen, die das Integral der erfassten reflektierten Leistung über der Zeit als das Integral einer Differenz zwischen einem reflektierten Signal (R(t)) und einem Referenzsignal (r₂(t)) bestimmen, und einen Referenzgenerator (60, 90, 100) umfassen, der so ausgeführt ist, dass er das Referenzsignal (r₂(t)) erzeugt durch Addieren einer anfänglichen Referenz (r₁(t)) zu einer Differenz aus der anfänglichen Referenz (r₁(t)) und dem reflektierten Signal (R(t)).

2. Leistungsverstärker nach Anspruch 1, wobei die Mittel (50) zum Bestimmen des Integrals unter Verwendung ausschließlich analoger Signalverarbeitungskomponenten implementiert sind.

3. Leistungsverstärker nach irgendeinem der vorangehenden Ansprüche, wobei die Mittel (50) zum Bestimmen des Integrals auf einem Substrat mit dem Verstärker (15) integriert sind.

4. Leistungsverstärker nach irgendeinem der vorangehenden Ansprüche, wobei der Referenzgenerator (60, 90, 100) so ausgeführt ist, dass er die anfängliche Referenz (r₁(t)) bei einem auswählbaren Wert ausgibt.

5. Leistungsverstärker nach irgendeinem der vorangehenden Ansprüche, wobei die Mittel (170) zum Regeln der Ausgangsleistung des Verstärkers (15) so ausgeführt sind, dass sie den Verstärkungsfaktor des Verstärkers (15) regeln.

6. Mobile, batteriebetriebene Vorrichtung (200), die einen Funk-Sendeempfänger aufweist, wobei der Sendeempfänger den Leistungsverstärker nach irgendeinem der vorangehenden Ansprüche aufweist.

7. Verfahren zum Regeln eines Leistungsverstärkers mit den Schritten Erfassen eines von einer Last an einem Ausgang des Verstärkers (15) reflektierten Signals, Bestimmen eines Integrals des erfassten reflektierten Signals (R(t)) über der Zeit, und Regeln einer Ausgangsleistung des Leistungsverstärkers entsprechend dem Integral, um die Ausgangsleistung zu erhöhen und ein durch Änderungen in der reflektierten Leistung hervorgerufenes Absinken der Ausgangsleistung zu kompensieren, und um die Ausgangsleistung zu verringern und eine durch Änderungen der reflektierten Leistung hervorgerufenes Ansteigen der Ausgangsleistung zu kompensieren, **gekennzeichnet durch**
Bestimmen des Integrals der erfassten reflektierten Leistung über der Zeit als das Integral einer Differenz zwischen dem reflektierten Signal (R(t)) und einem Referenzsignal (r₂(t)), und Erzeugen des Referenzsignals (r₂(t)) **durch** Addieren einer anfänglichen Referenz (r₁(t)) zu einer Differenz aus der anfänglichen Referenz (r₁(t)) und dem reflektierten Signal (R(t)).

## Revendications

1. Amplificateur de puissance RF ayant un amplificateur (15) et un contrôleur (20, 170) ayant des moyens (20) pour détecter une puissance réfléchie par une charge à la sortie de l'amplificateur (15), et des moyens (170) pour commander une puissance de sortie de l'amplificateur (15) en réponse à une intégrale au cours du temps de la puissance réfléchie détectée, afin d'augmenter la puissance de sortie pour compenser une chute de la puissance de sortie causée par des variations de la puissance réfléchie, et pour diminuer la puissance de sortie pour compenser une augmentation de la puissance de sortie causée par des variations de la puissance réfléchie, **caractérisé par le fait que**
les moyens (170) pour commander comprennent des moyens (50) pour déterminer l'intégrale au cours du temps de la puissance réfléchie détectée en tant qu'intégrale d'une différence entre un signal réfléchi (R(t)) et un signal de référence (r₂(t)), et comprennent un générateur de référence (60, 90, 100) agencé de manière à générer le signal de référence (r₂(t)) en additionnant une référence initiale (r₁(t)) à une différence entre la référence initiale (r₁(t)) et le signal réfléchi (R(t)).

2. Amplificateur de puissance selon la revendication 1, les moyens (50) pour déterminer l'intégrale étant mis en oeuvre en utilisant uniquement des éléments de traitement du signal analogiques.

3. Amplificateur de puissance selon l'une quelconque des revendications précédentes, les moyens (50) pour déterminer l'intégrale étant intégrés sur un substrat avec l'amplificateur (15).

4. Amplificateur de puissance selon l'une quelconque des revendications précédentes, le générateur de référence (60, 90, 100) étant agencé de manière à fournir en sortie la référence initiale (r₁(t)) à une valeur pouvant être sélectionnée.

5. Amplificateur de puissance selon l'une quelconque des revendications précédentes, dans lequel les moyens (170) pour commander la puissance de sortie de l'amplificateur (15) sont agencés de manière à commander le gain de l'amplificateur (15).

6. Dispositif mobile alimenté par une batterie (200) ayant un émetteur-récepteur sans fil, l'émetteur-récepteur ayant un amplificateur de puissance selon l'une quelconque des revendications précédentes.

7. Procédé de commande d'un amplificateur de puissance ayant comme étapes la détection d'un signal réfléchi par une charge à la sortie de l'amplificateur (15), la détermination d'une intégrale au cours du temps du signal réfléchi détecté (R(t)) et la commande d'une puissance de sortie de l'amplificateur de puissance en fonction de l'intégrale, afin d'augmenter la puissance de sortie pour compenser une chute de la puissance de sortie causée par des variations de la puissance réfléchie, et pour diminuer la puissance de sortie pour compenser une augmentation de la puissance de sortie causée par des variations de la puissance réfléchie, **caractérisé par** la détermination de l'intégrale au cours du temps de la puissance réfléchie détectée en tant qu'intégrale d'une différence entre le signal réfléchi (R(t)) et un signal de référence (r₂(t)), et la génération du signal de référence (r₂(t)) par addition d'une référence initiale (r₁(t)) à une différence entre la référence initiale (r₁(t)) et le signal réfléchi (R(t)).
